# EUROPEAN PATENT SPECIFICATION

(11) **EP 2 988 418 B1**
(45) Date of publication and mention of the grant of the patent: **30.12.2020**
(21) Application number: 15181721.0
(22) Date of filing: 20.08.2015
(51) Int. Cl.: H03K 17/082, G05F 3/08, H02M 3/158, H02J 1/10, H03K 17/12, H03K 17/16

(54) **SOLID-STATE POWER CONTROLLER CHANNEL PROTECTION SYSTEMS AND METHODS**
KANALSCHUTZSYSTEME UND -VERFAHREN FÜR RÖHRENLOSEN LEISTUNGSREGLER
COMMANDE DE PUISSANCE À SEMI-CONDUCTEURS, SYSTÈMES ET PROCÉDÉS DE PROTECTION DE CANAL

(30) Priority: 20.08.2014 US 201414464573
(43) Date of publication of application: 24.02.2016
(73) Proprietor: Hamilton Sundstrand Corporation, Charlotte, NC 28217 (US)
(72) Inventor: Dickey, John A., Caledonia, IL Illinois 61011 (US)
(74) Representative: Dehns

(56) References cited:
- EP-A2- 2 642 608
- WO-A2-2005/015741
- US-A- 5 804 859
- US-A1- 2006 250 742
- US-A1- 2013 051 100

## Description

### FIELD

The present disclosure relates to solid-state power controllers and their components, and more particularly, to the interaction of an overload protection system and a solid-state power controller.

### BACKGROUND

Solid-state power controllers ("SSPC") have been designed to have a current channel that can be combined with current channels of other SSPCs to achieve a desired current capacity. However, the individual channels may experience different load conditions, for example, in the event that one or more individual channel fails, or in the event that outrush current demands vary or component values vary. Some channels may become overloaded while other channels may remain within operating specifications. In some instances, a so-called "instant trip" monitoring circuit is implemented, however, a fault may occur so rapidly that an interrupt signal from an instant trip monitoring circuit cannot reach the SSPCs in time to direct the SSPCs to trip the circuit offline before one or more channels experience an overload condition. Moreover, in the event, that a load draws a prolonged outrush current, a cascading trip may occur as channels are incrementally overloaded and trip offline.

US 5,804,859 relates to a semiconductor device for switching a heavy current flow. US 2006/0250742 relates to protection of a power transistor. WO 2005/015741 relates to a circuit for power conversions. EP 2,642,608 relates to solid state power controllers.

### SUMMARY

A scalable solid-state power controller system is provided as claimed in claim 1.

A method of operating a solid-state power controller is provided as claimed in claim 15.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.
FIG. 1 depict block diagrams of a circuit containing a scalable SSPC system having one or more SSPC in accordance with various embodiments;
FIG. 2 depicts a block diagram of a SSPC in accordance with various embodiments;
FIG. 3 depicts a detailed view of a SSPC in accordance with various embodiments; and
FIG. 4 depicts a method whereby a scalable SSPC system may be operated in accordance with various embodiments.

### DETAILED DESCRIPTION

The detailed description of exemplary embodiments herein makes reference to the accompanying drawings, which show exemplary embodiments by way of illustration and their best mode. While these exemplary embodiments are described in sufficient detail to enable those skilled in the art to practice the disclosure, it should be understood that other embodiments may be realized and that logical changes may be made without departing from the scope of the disclosure. Thus, the detailed description herein is presented for purposes of illustration only and not of limitation. For example, the steps recited in any of the method or process descriptions may be executed in any order and are not necessarily limited to the order presented. Furthermore, any reference to singular includes plural embodiments, and any reference to more than one component or step may include a singular embodiment or step.

The present disclosure relates to the design of a scalable SSPC system and, more particularly, to the design of a scalable SSPC system comprising a SSPC with self-protection features. Aspects of the designs disclosed herein may be applicable to other power supplies or power sources.

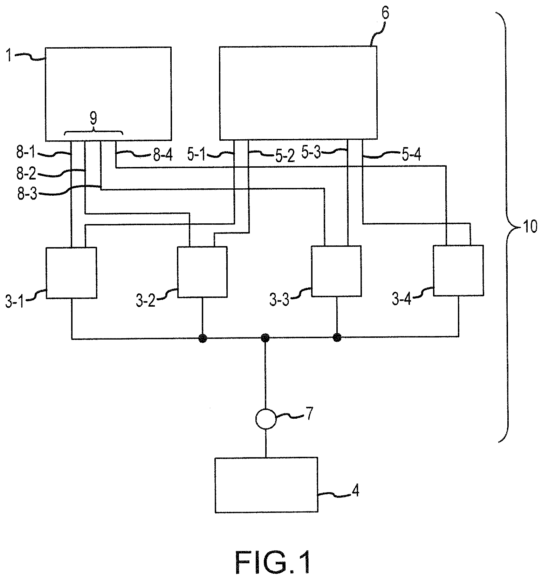

According to various embodiments, and with reference to FIG. 1, a scalable SSPC system 10 may comprise a system whereby electrical power is provided for use by a load 4. Moreover, the scalable SSPC system 10 may condition the electrical power so that its current and voltage remains within defined boundaries and may protect itself, and/or the load 4, by preventing the current and voltage from unwanted deviations. For example, the scalable SSPC system 10 may terminate the provision of power, and/or restrict the output current in event of an unexpected drop in load 4's impedance/resistance, such as, during a short-circuit event, or in the event of another fault. For instance, the scalable SSPC system 10 may comprise one or more SSPC 3, whereby the current and or voltage presented at combined channel output 7 may be controlled.

In various embodiments, the scalable SSPC system 10 may comprise a power source 1, a controller 6, a SSPC 3, and a combined channel output 7. The power source 1 may provide electrical power via a channel 8 to one or more SSPC 3, from which it is output at combined channel output 7 in response to a control signal 5 comprising directions from controller 6 to the SSPC 3, and in response to protective actions taken by the SSPC 3 both independently and in response to the control signal 5.

With continuing reference to FIG. 1, a scalable SSPC system 10 may comprise one or more SSPC 3. For example, a scalable SSPC system 10 may comprise a first SSPC 3-1, a second SSPC 3-2, a third SSPC 3-3, a fourth SSPC 3-4 and/or any number of SSPCs 3. Each SSPC may receive electrical power via a channel 8. For example, the first SSPC 3-1 may receive electrical power via a first channel 8-1, the second SSPC 3-2 may receive electrical power via a second channel 8-2, the third SSPC 3-3 may receive electrical power via a third channel 8-3, and the fourth SSPC 3-4 may receive electrical power via a fourth channel 8-4. The electrical power may be combined by the various SSPCs at combined channel output 7. Each SSPC may receive a corresponding control signal 5 from the controller 6. For example, the first SSPC 3-1 may receive a first control signal 5-1, the second SSPC 3-2 may receive a second control signal 5-2, the third SSPC 3-3 may receive a third control signal 5-3, and the fourth SSPC 3-4 may receive a fourth control signal 5-4. By controlling each SSPC, the controller 6 may logically combine SSPCs to increase and/or decrease the current provided at combined channel output 7, as well as control the amount of current drawn from each channel 8.

A power source 1 may comprise any apparatus whereby electrical power may be provided. For example, the power source 1 may be a solid-state power supply. The power source 1 may be a linear power supply, or a switching-mode power supply, or a power supply operating according to a variety of different modes. The power source 1 may further comprise a generator, an alternator, a fuel cell, or another source of electrical energy and in various embodiments may be configured for aircraft use. For example, the power source 1 may comprise a generator mechanically connected with a turbine engine, such as an aircraft engine or an aircraft auxiliary power unit engine. Although, scalable SSPC systems 10 disclosed herein involve power sources 1 that provide direct current, in further embodiments, a power source 1 may provide an alternating current, or may provide any form of electrical power.

In various embodiments, the scalable SSPC system 10 may comprise a controller 6. The controller 6 may comprise a digital controller, an analog controller, or may comprise a combination of digital and analog components. The controller 6 may comprise a logical division of one or more of an aircraft data bus, a remote data concentrator, a flight computer, a full authority digital engine control ("FADEC"), an electronic engine controller ("EEC"), an engine control unit ("ECU"), and/or any other aircraft system. The controller 6 may comprise a processor and a tangible non-transitory memory, as well as a digital-to-analog converter ("DAC"), an analog to digital converter ("ADC"), and/or discrete logic components, for example, TTL and/or CMOS level logic devices. The controller 6 provides a control signal 5 to the SSPC 3 as discussed further herein. For example, the controller 6 may provide a first control signal 5-1 to the first SSPC 3-1 a second control signal 5-2 to the second SSPC 3-2, a third control signal 5-3 to the third SSPC 3-3, a fourth control signal 5-4 to the fourth SSPC 3-4, and/or any number of control signals 5 to any number of SSPCs 3.

The scalable SSPC system 10 may comprise one or more SSPC 3. A SSPC 3 may comprise analog components and/or digital components configured to limit the current and/or voltage output from the power source 1 to the combined channel output 7. For example, the SSPC 3 may sense overcurrent conditions. Moreover, in embodiments comprising a plurality of SSPCs 3, the SSPCs 3 may be directed by the controller 6 to balance the total current provided at the combined channel output 7 among different channels 8 of the power source 1.

Having discussed various aspects of a scalable SSPC system 10, the power source 1 may comprise a channel bank 9. The channel bank 9 may comprise a plurality of output channels. These channels may be combined in parallel. For example, a SSPC may be associated with each channel and the controller may selectively turn different SSPCs on and off in order to logically combine channels together to provide current to the combined channel output 7. In this manner, the total current supplied by the power source 1 may be greater than the power supplied by any one channel. For example, the channel bank 9 may comprise any number of channels. In various embodiments, the channel bank 9 comprises two channels, or three channels, or four channels or any number of channels. In further embodiments, the channel bank 9 comprises only one channel, or comprises various channels combined in various different ways. For the purpose of illustration, a channel bank 9 is illustrated in FIG. 1, comprising four channels: Channel A 8-1, Channel B 8-2, Channel C 8-3, and Channel D 8-4. These channels may be combined in parallel by the SSPCs 3 and the aggregate current may be provided at combined channel output 7. In various embodiments, each channel may have a lesser current capacity than the combined channel output 7. In various embodiments, the SSPCs 3 are configured to maintain each channel within that channel's current capacity and to balance the current drawn among the different channels. In this manner, each channel can be maintained within its limits, even if the combined channel output 7 is of a significantly greater magnitude than an individual channel's limit.

Moreover, while FIG. 1 shows a channel bank 9 having four channels 8-1, 8-2, 8-3, and 8-4, this grouping is for example only and any number of channels 8 and/or channel banks 9 may be combined, depending on the characteristics of the output power desired. For further example, in various embodiments, a channel bank may comprise a single channel, for example, in the event that a single channel can provide the current desired at combined channel output 7.

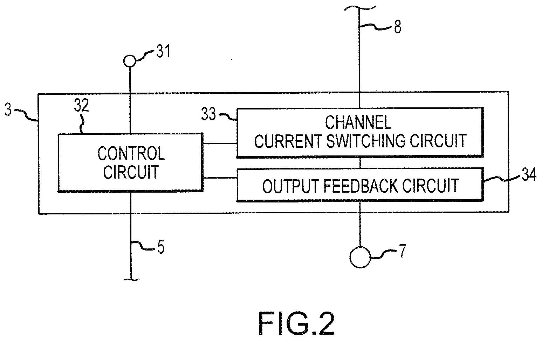

Now, with reference to FIG. 2, a SSPC 3 is presented in greater detail. In various embodiments, a SSPC 3 comprises a channel current switching circuit 33, an output feedback circuit 34, and a control circuit 32. These various components are connected in electrical communication.

A channel current switching circuit 33 is connected to a channel 8. For example, Channel A 8-1, Channel B 8-2, Channel C 8-3, and Channel D 8-4 each are connected to the channel current switching circuit 33 of a separate first SSPC 3-1, second SSPC 3-2, third SSPC 3-3, and fourth SSPC 3-4. The channel current switching circuit 33 regulates the current flowing from the connected channel, in response to the control circuit 32 and the output feedback circuit 34. The current then passes through the output feedback circuit 34 and out via the combined channel output 7 to a load 4 (see FIG. 1).

An output feedback circuit 34 is connected to the channel current switching circuit 33 and the control circuit 32. The output feedback circuit 34 monitors the current passing out of the SSPC 3 to the combined channel output 7 and provides a signal to the control circuit 32 in response to the current passing out of the SSPC 3. For example, the output feedback circuit 34 may provide a signal indicating that the control circuit 32 should direct the channel current switching circuit 33 to reduce and/or limit the current provided to the combined channel output 7 from the SSPC 3 in response to the output feedback circuit 34 detecting that the current is too high and/or is approaching a desired limit. The output feedback circuit 34 may provide a signal to the control circuit 32 indicating that the channel current switching circuit 33 should increase the path resistance between the channel 8 and the combined channel output 7 in order to prevent the combined current from all SSPCs 3, and/or the individual current from a single SSPC 3 from becoming too high, or reduce the path resistance to prevent the combined current from all SSPCs 3, and/or the individual current from a single SSPC 3 from becoming too low. Moreover, the output feedback circuit 34 may contain reactive passive components, for example, to immediately respond to various circuit conditions, for example, inductive components whereby the deleterious effects of an excessive outrush current may immediately be compensated.

A control circuit 32 may receive a control signal 5 from a controller 6 and may receive a voltage reference 31. In various embodiments, the voltage reference 31 may correspond to the nominal voltage presented at the channel 8, although it may be any desired value. The control circuit 32 may adjust the current drawn from the channel 8 in response to the control signal 5 and the voltage reference 31.

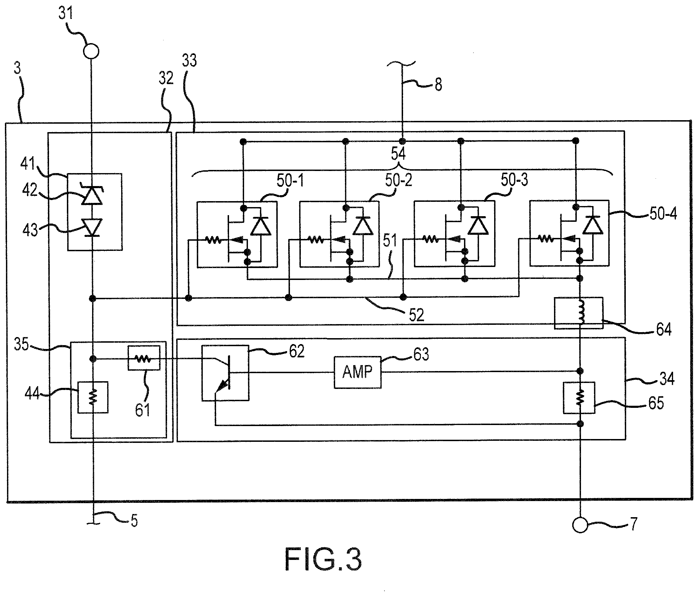

Now, with reference to FIG. 3, a detailed schematic diagram of an example SSPC 3 is provided. As previously discussed, a SSPC 3 may comprise a channel current switching circuit 33, an output feedback circuit 34, and a control circuit 32.

A channel current switching circuit 33 may comprise a circuit arranged to limit the current provided by the channel 8. For instance, the channel current switching circuit 33 may comprise a current limiter bank 54. The current limiter bank 54 may comprise a plurality of current limiters corresponding in number to the maximum amount of current that the connected channel 8 can provide divided by the current handling capacity of each current limiter. For example, the current limiter bank 54 may comprise a first current limiter 50-1, a second current limiter 50-2, a third current limiter 50-3, and a fourth current limiter 50-4, all connected in parallel. Moreover, the channel current switching circuit 33 may optionally include an inductive damper 64.

Each current limiter may comprise a transistor. The control circuit 32 and the output feedback circuit 34 may control the current limiters. In addition, the transistor may comprise a field-effect transistor. Thus, in various embodiments, the control circuit 32 and the output feedback circuit 34 may control the current limiters by controlling the gate of each transistor. In this manner, a selectably conductive path may be controlled corresponding to each channel of the channel bank 9. In various embodiments, the gate voltage of the transistor may be changed by the control circuit 32 and the output feedback circuit 34. Furthermore, in various embodiments, the transistor gate voltage of each current limiter may be changed by the control circuit 32 and the output feedback circuit 34 in unison, for instance, the gates may all be connected to a gate control bus 52. In this manner, the resistivity of the source-drain conduction path of the transistors may be varied, thus variously limiting the amount of current flowing through the transistors. One end of each source-drain conduction path of a transistor may be connected in parallel to a channel 8, while the other end may be connected in parallel to a current limiter bus 51. Thus, the transistors provide overcurrent protection to the channel 8, as well as cooperating with the transistors of the channel current switching circuits 33 of other SSPCs to actively balancing the current drawn by a load among all channels 8 of the channel bank 9, as directed by the controller 6 and/or the channel current switching circuit's respective corresponding output feedback circuit 34.

The transistors may be operated in the linear region (also known as the ohmic or Triode mode). In this manner, the resistivity of the source-drain conduction path may be varied; however, under some circuit conditions, one or more transistors may be operated in the active region, such as when maximum current is desired to be supplied. Each transistor may be a p-channel FET, or an n-channel FET. Alternatively, other transistors such as bipolar junction transistors ("BJTs"), whether NPN or PNP, may be implemented, or other voltage-controlled switches or other current-controlled switches may be implemented. In various embodiments, the current limiter further comprises a protection resistor connected in series with the gate of each transistor.

The current limiter bus 51 may comprise a bus connecting the current output of each current limiter of the current limiter bank 54. These outputs may be combined, and connected to the combined channel output 7, for example, via a path through the output feedback circuit 34.

Similarly, the gate control bus 52 may comprise a bus connecting the gates of the transistors of the current limiter bank 54 together. These gates may be connected together so that the gate voltage may be changed in unison across all current limiters of current limiter bank 54 (by the control circuit 32 and the output feedback circuit 34). As a result, the current provided by the combined channel output 7 may be balanced across all the channels 8 of the channel bank 9, via individualized control of each SSPC's gate control bus 52 via control signals 5.

An inductive damper 64 may be disposed in series with the current limiter bus 51 and the combined channel output 7. The inductive damper 64 may comprise an inductor or any other component configured to dampen changes in current over time. In this manner, large startup currents may be dampened, protecting the load, and fluctuations/noise caused by the load, such as switching noise, may be dampened, protecting the scalable SSPC system 10.

An output feedback circuit 34 may comprise a circuit arranged to monitor the combined current provided at the combined channel output 7 and provide feedback to the channel current switching circuit 33 instructing the channel current switching circuit 33 to increase or decrease the current provided. For example, the output feedback circuit 34 may comprise a feedback amplifier 62, and a sense resistor 65. In various embodiments, the output feedback circuit 34 may optionally include a signal amplifier 63.

A feedback amplifier 62 may comprise a current controlled amplifier. For example, the feedback amplifier 62 may comprise a bipolar junction transistor. Moreover, the sense resistor 65 may comprise a resistor disposed between the channel current switching circuit 33 and the combined channel output 7. As current flows through the sense resistor 65, a voltage is developed across the sense resistor 65. The base of the bipolar junction transistor and the emitter of the bipolar junction transistor may be connected to opposite sides of the sense resistor 65. In this manner, the voltage developed across the sense resistor 65 controls the resistivity of the bipolar junction transistor collector-emitter pathway. The collector may be connected to a control circuit 32 (for example, the control circuit/feedback circuit balancer 35 discussed further herein), which may then connect to the gate control bus 52. In this manner, the voltage present on the gate control bus 52 may be controlled in response to the current flowing through the sense resistor 65 so that a feedback loop is established wherein the feedback amplifier 62 controls the gate control bus voltage in response to the current output of the SSPC (which is then combined with that of any other SSPCs and provided to combined channel output 7). Thus, the gate control bus 52 voltage may change in response to the output current to cause the channel current switching circuit 33 to limit the output current and bring it into compliance with the desired current limit, such as in the event of a fault condition. Some fault conditions may include a short circuit or startup load variations, such as outrush current during a transient event.

A signal amplifier 63 may be disposed between the sense resistor 65 and the base of the bipolar junction transistor comprising the feedback amplifier 62. The signal amplifier 63 may increase and/or decrease the sensitivity of the output feedback circuit 34, or may otherwise condition the behavior of the output feedback circuit 34 as desired for a particular application. In various embodiments, the amplifier comprises a solid-state operational amplifier, though any amplifier configuration may be implemented. In further embodiments, the signal amplifier 63 is omitted.

With ongoing reference to FIG. 3, a control circuit 32 may be incorporated as well. The control circuit 32 may include a overvoltage protector 41 and a control circuit/feedback circuit balancer 35. The overvoltage protector 41 may be in electrical communication with a voltage reference 31. The overvoltage protector 41 may comprise a circuit to condition the voltage reference 31 and provide power to the gate control bus 52 during certain scenarios, such as a transient overvoltage condition, to force current limiters 50 to an on condition until the scenario, such as a transient overvoltage condition, has passed. Thus the overvoltage protector 41 may provide overvoltage protection, such as lightning protection. In various embodiments, the overvoltage protector 41 comprises a Zener diode 42 and a power diode 43. The Zener diode 42 may be arranged in a reverse biased configuration in order to regulate the voltage supplied by the overvoltage protector 41 while the power diode 43 may be arranged in a forward biased configuration in order to provide reverse current protection to voltage reference 31 and enable proper functioning of control circuit/feedback circuit balancer 35.

The control circuit 32 may selectively sink the gate control bus 52 to ground, thus selectively changing the voltage on the gate control bus 52. Thus, the control circuit 32 may comprise a control circuit/feedback circuit balancer 35 comprising a voltage divider to join different signals on the gate control bus 52. For instance, the control signal 5 may be connected to the control circuit 32. A control resistor 44 may be disposed in the circuit path. Similarly, the channel current switching circuit 33 may be connected to the control circuit 32 and a feedback resistor 61 may be disposed in the circuit path between the collector of the feedback amplifier 62 and the overvoltage protector 41. The channel current switching circuit 33 and the control signal 5 may selectively change the voltage on the gate control bus 52. For example, during normal operation, control signal 5 may control the voltage present on gate control bus 52, however, during an overcurrent condition, the output feedback circuit 34 may lower the voltage on the gate control bus 52 and during an overcurrent condition, overvoltage protector 41 may increase the voltage on the gate control bus 52. Thus, one may appreciate that a parallel voltage divider may be established by the feedback resistor 61 and the control resistor 44 which are connected in parallel (and are in series with the overvoltage protector 41). The gate control bus 52 may also be connected in parallel with the feedback resistor 61 and the control resistor 44. Thus, the voltage presented on the gate control bus 52 may be varied in response to the control signal 5, which may comprise a resistivity of the path through the controller 6, and in response to the resistivity of the collector-emitter path through the bipolar junction transistor comprising the feedback amplifier 62. In this manner, the controller 6 may control the current supplied by the SSPC to the combined channel output 7 through the channel 8, and the output feedback circuit 34 may also control the current supplied at the combined channel output 7 through the channel 8.

The feedback resistor 61 and control resistor 44 may be selected to enable a prioritization of the different control functions connected to gate control bus 52. For example, if overvoltage protector 41 conducts due to an overvoltage, overvoltage protector 41 has the highest priority because, among other reasons, there is no resistor between overvoltage protector 41 and the gate control bus 52. If there is no overvoltage, but there is an overcurrent, feedback resistor 61 facilitates a controlled reduction in the voltage on gate control bus 52. If both an overvoltage and overcurrent condition occur at the same time, then overvoltage protector 41 may override feedback resistor 61 and control resistor 44 because it provides a direct path without a resistor - thus, the current limiters 50 may be forced on, even though an overcurrent condition exists, in order to address the overvoltage condition as a higher priority condition. Similarly, during normal operation, feedback resistor 61 may provide no control function and instead the control signal 5 via control resistor 44 may control the voltage on gate control bus 52.

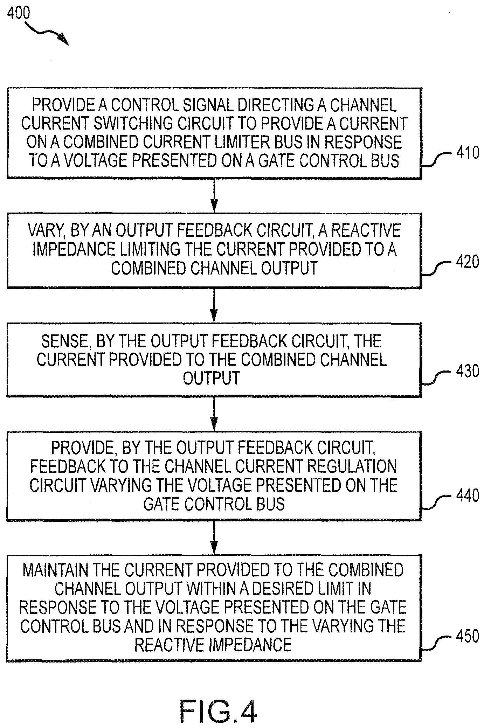

Having discussed various aspects of a scalable SSPC system 10 and an SSPC 3, a SSPC 3 may be operated according to various methods. For example, with reference to FIGs. 1, 3, and 4, a method 400 is provided wherein the controller 6 may provide a control signal 5 directing a channel current switching circuit 33 to provide a current on a current limiter bus 51 in response to a voltage presented on a gate control bus 52 (Step 410). In various embodiments, the load 4 may be a reactive load, so that a large outrush current is demanded at initial startup. Thus, the output feedback circuit 34 may vary a reactive impedance limiting the current provided to a combined channel output 7 (Step 420). Furthermore, the SSPC 3 may sense, by the output feedback circuit 34, the current provided to the combined channel output 7 (Step 430). The output feedback circuit 34 may provide feedback to the channel current switching circuit 33 varying the voltage presented on the gate control bus 52 (Step 440). In this manner, the current provided to the combined channel output 7 may be maintained within a desired limit in response to the voltage presented on the gate control bus 52 and in response to the varying the reactive impedance (Step 450).Thus, the SSPC 3 may provide active current regulation, such as in response to transient events, for example, a load fault, such as outrush currents short circuits, and/or overload conditions.

While the systems described herein have been described in the context of scalable SSPC systems for implementation in aircraft applications; however, one will appreciate in light of the present disclosure, that the systems described herein may be used in various other applications, for example, different vehicles, different power applications, and different circuit protection arrangements, or any other vehicle or device, or in connection with industrial processes, or propulsion systems, or any other system or process having need for a power supply with channel protection.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the inventions. The scope of the inventions is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C.

Systems, methods and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Furthermore, no element, component, or method step in the present disclosure is intended to be dedicated to the public regardless of whether the element, component, or method step is explicitly recited in the claims. As used herein, the terms "comprises", comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A scalable solid-state power controller system (10) comprising:
a power source (1) comprising a channel bank (9) comprising a plurality of output channels (8-1,8-2,8-3,8-4) comprising a first output channel (8-1) and a second output channel (8-2);
a first solid-state power controller (3-1) comprising a first channel current switching circuit (33);
a second solid-state power controller (3-2) comprising a second channel current switching circuit (33); each solid-state power controller comprising:
an output feedback circuit (34); and
a control circuit (32) comprising an overvoltage protector (41) and a control circuit/feedback circuit balancer (35), wherein the control circuit/feedback circuit balancer (35) comprises a feedback resistor (61) connected to a control resistor (44), the feedback resistor (61) and the control resistor (44) being connected with the overvoltage protector (41) by a common node between the feedback resistor (61) and the control resistor (44);
the output feedback circuit being connected to the current switching circuit (33) and the control circuit (32), the output feedback circuit (34) being configured to monitor the current passing out of the solid-state power controller and provide a signal to the feedback resistor in response to the current passing out of the solid-state power controller;
a controller (6) in electrical communication with the first solid-state power controller (3-1) and configured to provide a first control signal (15-1) to the control resistor (44-1) of the first solid-state power controller, wherein the controller is in electrical communication with the second solid-state power controller (3-2) and configured to provide a second control signal (5-2) to the control resistor (44-2) of the second solid-state power controller; and
a combined channel output (7),
wherein the first channel current switching circuit (33) is disposed in series between the combined channel output (7) and the first output channel (8-1),
wherein the second channel current switching circuit (33) is disposed in series between the combined channel output (7) and the second output channel (8-2),
wherein the first channel current switching circuit (33) is adapted to control a first current supplied by the first output channel (8-1) in response to the first control signal from the controller (6), and
wherein the second channel current switching circuit (33) is adapted to control a second current supplied by the second output channel (8-2) in response to the second control signal from the controller (6).

2. The scalable solid-state power controller system according to claim 1, wherein each of the plurality of output channels (8-1...8-4) have different current capacities.

3. The scalable solid-state power controller system according to claim 1 or 2, wherein a current capacity of the combined channel output (7) is greater than a current capacity of at least one of the plurality of output channels (8-1 ...8-4).

4. The scalable solid-state power controller system according to claim 1, 2 or 3, wherein the first channel current switching circuit (33) comprises:
a channel current limiter bank (54) comprising a plurality of variable conduction paths;
a bus (51) comprising a single conduction path, in electrical communication with each variable conduction path of the channel current limiter bank (54); and
a gate control bus (52) whereby the plurality of variable conduction paths are controlled.

5. The scalable solid-state power controller system according to claim 4, wherein each of the variable conduction path comprises a field-effect transistor.

6. The scalable solid-state power controller system according to claim 4 or 5, wherein
the gate control bus (52) is controlled by the output feedback circuit (34) and the control circuit (32);
wherein the control circuit (32) is in electrical communication with the controller (6) and the gate control bus (52), and
wherein the output feedback circuit (34) is in electrical communication with the combined channel output (7) and the gate control bus (52).

7. The scalable solid-state power controller system according to claim 6, wherein the output feedback circuit (34) of the first solid-state power controller (3-1) comprises:
a sense resistor (65) in series with the combined channel output (7);
a bipolar junction transistor comprising a base, a collector, and an emitter, wherein the sense resistor (65) is in electrical communication with the base and the emitter, and wherein the collector is in electrical communication with the control circuit (32).

8. The scalable solid-state power controller system according to claim 7, wherein the output feedback circuit (34) of the first solid-state power controller (3-1) comprises an amplifier (63) disposed between the sense resistor (65) and the base.

9. The scalable solid-state power controller system according to claim 7 or 8, wherein the first channel current switching circuit (33) comprises an inductive damper (64) at least one of: disposed between the current limiter bus (51) of the combined channel output (7) and the sense resistor (65) of the output feedback circuit (34), and between the sense resistor (65) of the output feedback circuit (34) and the combined channel output (7).

10. The scalable solid-state power controller system according to any of claims 6 to 9, wherein the
control circuit/feedback circuit balancer (35) is in electrical communication with the controller (6), the output feedback circuit (34), and the gate control bus (52), whereby the gate control bus (52) is controlled in response to the controller (6) and the output feedback circuit (34).

11. The scalable solid-state power controller system according to claim 10, wherein the
control resistor (44) is in series with the controller (6) and the gate control bus (52); and
the feedback resistor (61) is in series with the collector of the bipolar junction transistor of the output feedback circuit (34) and the gate control bus (52).

12. The scalable solid-state power controller system according to any of claims 4 to 11, wherein the overvoltage protector (41) is in series with a voltage reference (31) and the gate control bus (52).

13. The scalable solid-state power controller system according to claim 12, wherein the overvoltage protector (31) of the first solid-state power controller (3-1) comprises:
a Zener diode (42) in reverse-biased series with the voltage reference (31); and
a power diode (43) in forward-biased series between the Zener diode (42) and the gate control bus (52).

14. The scalable solid-state power controller system according to any preceding claim, wherein the first solid-state power controller (3-1) further comprises a reactive load (4) connected in electrical communication with the combined channel output (7).

15. A method of operating a solid-state power controller (3-1,3-2,3-3,3-4) comprising:
providing, by a controller (6), a first and second control signal (5-1,5-2) directing a first and second channel current switching circuit (33) to provide a current on a first and second current limiter bus (51) in response to a voltage presented on a first and second gate control bus (52);
providing, by the controller (6), a voltage reference to the first and second channel current switching circuit via a first and second overvoltage protector (41) and to a first and second circuit balancer (35) via the first and second overvoltage protector (41), the voltage reference corresponding to a nominal voltage presented at a channel;
sensing, by the first and second output feedback circuit (34), the current provided to the combined channel output (7);
providing, by the first and second output feedback circuit (34), feedback to the first and second channel current switching circuit (33) varying the voltage presented on the first and second gate control bus (52); and
maintaining the current provided to the combined channel output (7) within a desired limit in response to the voltage presented on the first and second gate control bus (52),
wherein the first and second circuit balancer comprises a feedback resistor (61) and a control resistor (44) connected with the first and second overvoltage protector by a common node between the feedback resistor and the control resistor, the first and second control signal being provided to the control resistor of the first and second circuit balancer.

## Patentansprüche

1. Skalierbares Festkörperleistungsreglersystem (10), umfassend:
eine Leistungsquelle (1), die eine Kanalbank (9) umfasst, die eine Vielzahl von Ausgangskanälen (8-1, 8-2, 8-3, 8-4) umfasst, die einen ersten Ausgangskanal (8-1) und einen zweiten Ausgangskanal (8-2) umfasst;
einen ersten Festkörperleistungsregler (3-1), der einen Kanalstromschaltkreis (33) umfasst;
einen zweiten Festkörperleistungsregler (3-2), der einen zweiten Kanalstromschaltkreis (33) umfasst; wobei jeder Festkörperleistungsregler Folgendes umfasst:
einen Ausgangsrückkopplungskreis (34); und
einen Regelkreis (32), der einen Überspannungsschutz (41) und einen Regelkreis/Rückkopplungskreis-Balancer (35) umfasst, wobei der Regelkreis/Rückkopplungskreis-Balancer (35) einen Rückkopplungswiderstand (61) umfasst, der mit einem Regelwiderstand (44) verbunden ist, wobei der Rückkopplungswiderstand (61) und der Regelwiderstand (44) durch einen gemeinsamen Knoten zwischen dem Rückkopplungswiderstand (61) und dem Regelwiderstand (44) mit dem Überspannungsschutz (41) verbunden sind;
wobei der Ausgangsrückkopplungskreis mit dem Stromschaltkreis (33) und dem Regelkreis (32) verbunden ist, wobei der Ausgangsrückkopplungskreis (34) konfiguriert ist, um den Strom zu überwachen, der aus dem Festkörperleistungsregler austritt, und als Reaktion darauf, dass der Strom aus dem Festkörperleistungsregler austritt, ein Signal an dem Rückkopplungswiderstand bereitzustellen;
ein Regler (6) in elektrischer Kommunikation mit dem ersten Festkörperleistungsregler (3-1) steht, der konfiguriert ist, um ein erstes Regelsignal (15-1) an dem Regelwiderstand (44-1) des ersten Festkörperleistungsreglers bereitzustellen, wobei der Regler in elektrischer Kommunikation mit dem zweiten Festkörperleistungsregler (3-2) steht und konfiguriert ist, um ein zweites Regelsignal (5-2) an dem Regelwiderstand (44-2) des zweiten Festkörperleistungsreglers bereitzustellen; und
einen kombinierten Kanalausgang (7),
wobei der erste Kanalstromschaltkreis (33) zwischen dem kombinierten Kanalausgang (7) und dem ersten Ausgangskanal (8-1) in Reihe geschaltet ist,
wobei der zweite Kanalstromschaltkreis (33) zwischen dem kombinierten Kanalausgang (7) und dem zweiten Ausgangskanal (8-2) in Reihe geschaltet ist,
wobei der erste Kanalstromschaltkreis (33) angepasst ist, um einen ersten Strom, der durch den ersten Ausgangskanal (8-1) bereitgestellt ist, als Reaktion auf das erste Regelsignal von dem Regler (6) zu regeln, und
wobei der zweite Kanalstromschaltkreis (33) angepasst ist, um einen zweiten Strom, der durch den zweiten Ausgangskanal (8-2) bereitgestellt ist, als Reaktion auf das zweite Regelsignal von dem Regler (6) zu regeln.

2. Skalierbares Festkörperleistungsreglersystem nach Anspruch 1, wobei jeder der Vielzahl von Ausgangskanälen (8-1 ...8-4) unterschiedliche Stromkapazitäten aufweist.

3. Skalierbares Festkörperleistungsreglersystem nach Anspruch 1 oder 2, wobei eine Stromkapazität des kombinierten Kanalausgangs (7) größer als eine Stromkapazität von zumindest einem der Vielzahl von Ausgangskanälen (8-1...8-4) ist.

4. Skalierbares Festkörperleistungsreglersystem nach Anspruch 1, 2 oder 3, wobei die erste Kanalstromschaltung (33) Folgendes umfasst:
eine Kanalstrombegrenzerbank (54), die eine Vielzahl von variablen Leiterbahnen umfasst;
einen Bus (51), der eine einzige Leiterbahn in elektrischer Kommunikation mit jeder variablen Leiterbahn der Kanalstrombegrenzerbank (54) umfasst; und
einen Gate-Steuerbus (52), durch den die Vielzahl von variablen Leiterbahnen gesteuert wird.

5. Skalierbares Festkörperleistungsreglersystem nach Anspruch 4, wobei jede der variablen Leiterbahmen einen Feldeffekttransistor umfasst.

6. Skalierbares Festkörperleistungsreglersystem nach Anspruch 4 oder 5, wobei der Gate-Steuerbus (52) durch den Ausgangsrückkopplungskreis (34) und den Regelkreis (32) gesteuert wird;
wobei der Regelkreis (32) in elektrischer Kommunikation mit dem Regler (6) und dem Gate-Steuerbus (52) steht; und
wobei der Ausgangsrückkopplungskreis (34) in elektrischer Kommunikation mit dem kombinierten Kanalausgang (7) und dem Gate-Steuerbus (52) steht.

7. Skalierbares Festkörperleistungsreglersystem nach Anspruch 6, wobei der Ausgangsrückkopplungskreis (34) des ersten Festkörperleistungsreglers (3-1) Folgendes umfasst:
einen Sensorwiderstand (65) in Reihe mit dem kombinierten Kanalausgang (7);
einen Bipolartransistor, der eine Basis, einen Kollektor und einen Emitter umfasst, wobei der Sensorwiderstand (65) in elektrischer Kommunikation mit der Basis und dem Emitter steht und wobei der Kollektor in elektrischer Kommunikation mit dem Regelkreis (32) steht.

8. Skalierbares Festkörperleistungsreglersystem nach Anspruch 7, wobei der Ausgangsrückkopplungskreis (34) des ersten Festkörperleistungsreglers (3-1) einen Verstärker (63) umfasst, der zwischen dem Sensorwiderstand (65) und der Basis angeordnet ist.

9. Skalierbares Festkörperleistungsreglersystem nach Anspruch 7 oder 8, wobei der erste Kanalstromschaltkreis (33) einen induktiven Dämpfer (64) von zumindest einem von Folgenden umfasst: zwischen dem Strombegrenzerbus (51) des kombinierten Kanalausgangs (7) und dem Sensorwiderstand (65) des Ausgangsrückkopplungskreises (34) angeordnet und zwischen dem Sensorwiderstand (65) des Ausgangsrückkopplungskreises (34) und dem kombinierten Kanalausgang (7) angeordnet.

10. Skalierbares Festkörperleistungsreglersystem nach einem der Ansprüche 6 bis 9, wobei der Regelkreis/Rückkopplungskreis-Balancer (35) in elektrischer Kommunikation mit dem Regler (6), dem Ausgangsrückkopplungskreis (34) und dem Gate-Steuerbus (52) steht, wobei der Gate-Steuerbus (52) als Reaktion auf den Regler (6) und den Ausgangsrückkopplungskreis (34) gesteuert wird.

11. Skalierbares Festkörperleistungsreglersystem nach Anspruch 10, wobei der Regelwiderstand (44) mit dem Regler (6) und dem Gate-Steuerbus (52) in Reihe geschaltet ist; und der Rückkupplungswiderstand (61) mit dem Kollektor des Bipolartransistors des Ausgangsrückkopplungskreises (34) und dem Gate-Steuerbus (52) in Reihe geschaltet ist.

12. Skalierbares Festkörperleistungsreglersystem nach einem der Ansprüche 4 bis 11, wobei der Überspannungsschutz (41) mit einer Spannungsreferenz (31) und dem Gate-Steuerbus (52) in Reihe geschaltet ist.

13. Skalierbares Festkörperleistungsreglersystem nach Anspruch 12, wobei der Überspannungsschutz (31) des ersten Festköperleistungsreglers (3-1) Folgendes umfasst:
eine Zener-Diode (42), die in Sperrrichtung vorgespannt mit der Spannungsreferenz (31) in Reihe geschaltet ist; und
eine Leistungsdiode (43), die in Durchlassrichtung vorgespannt zwischen der Zener-Diode (42) und dem Gate-Steuerbus (52) in Reihe geschaltet ist.

14. Skalierbares Festkörperleistungsreglersystem nach einem der vorangehenden Ansprüche, wobei der erste Festkörperleistungsregler (3-1) ferner eine reaktive Last (4) umfasst, die in elektrischer Kommunikation mit dem kombinierten Kanalausgang (7) angeschlossen ist.

15. Verfahren zum Betreiben eines Festkörperleistungsreglers (3-1, 3-2, 3-3, 3-4), umfassend:
Bereitstellen eines ersten und zweiten Regelsignals (5-1, 5-2), die einen ersten und zweiten Kanalstromschaltkreis (33) anleiten, einen Strom an einem ersten und zweiten Strombegrenzerbus (51) als Reaktion auf eine Spannung bereitzustellen, die an einem ersten und zweiten Gate-Steuerbus (52) dargestellt ist, durch einen Regler (6);
Bereitstellen einer Spannungsreferenz an dem ersten und zweiten Kanalstromschaltkreis über einen ersten und zweiten Überspannungsschutz (41) und an einem ersten und zweiten Schaltungsbalancer (35) über den ersten und zweiten Überspannungsschutz (41) durch den Regler (6), wobei die Spannungsreferenz einer Nennspannung entspricht, die an einem Kanal dargestellt ist;
Erfassen des Stroms, der an dem kombinierten Kanalausgang (7) bereitgestellt ist, durch den ersten und zweiten Ausgangsrückkopplungskreis (34);
Bereitstellen einer Rückkopplung an dem ersten und zweiten Kanalstromschaltkreis (33) durch den ersten und zweiten Ausgangsrückkopplungskreis (34), wobei die Spannung variiert wird, die an dem ersten und zweiten Gate-Steuerbus (52) bereitgestellt wird; und
Halten des Stroms, der an dem kombinierten Kanalausgang (7) bereitgestellt wird, innerhalb einer erwünschten Grenze als Reaktion auf die Spannung, die an dem ersten und zweiten Gate-Steuerbus (52)dargestellt wird,
wobei der erste und zweite Schaltungsbalancer einen Rückkopplungswiderstand (61) und einen Regelwiderstand (44) umfassen, die durch einen gemeinsamen Knoten zwischen dem Rückkopplungswiderstand und dem Regelwiderstand mit dem ersten und zweiten Überspannungsschutz verbunden sind, wobei das erste und zweite Steuersignal an dem Regelwiderstand des ersten und zweiten Schaltungsbalancers bereitgestellt werden.

## Revendications

1. Système de commande de puissance à semi-conducteurs évolutif (10) comprenant :
une source de puissance (1) comprenant une rangée de canaux (9) comprenant une pluralité de canaux de sortie (8-1, 8-2, 8-3, 8-4) comprenant un premier canal de sortie (8-1) et un second canal de sortie (8-2) ;
une première commande de puissance à semi-conducteurs (3-1) comprenant un premier circuit de commutation de courant de canal (33) ;
une seconde commande de puissance à semi-conducteurs (3-2) comprenant un second circuit de commutation de courant de canal (33) ; chaque commande de puissance à semi-conducteurs comprenant :
un circuit de rétroaction de sortie (34) ; et
un circuit de commande (32) comprenant un protecteur de surtension (41) et un équilibreur de circuit de commande/circuit de rétroaction (35), dans lequel l'équilibreur de circuit de commande/circuit de rétroaction (35) comprend une résistance de rétroaction (61) reliée à une résistance de commande (44), la résistance de rétroaction (61) et la résistance de commande (44) étant reliées au protecteur de surtension (41) par un nœud commun entre la résistance de rétroaction (61) et la résistance de commande (44) ;
le circuit de rétroaction de sortie étant relié au circuit de commutation de courant (33) et au circuit de commande (32), le circuit de rétroaction de sortie (34) étant configuré pour surveiller le courant sortant de la commande de puissance à semi-conducteurs et fournir un signal à la résistance de rétroaction en réponse au courant sortant de la commande de puissance à semi-conducteurs ;
une commande (6) en communication électrique avec la première commande de puissance à semi-conducteurs (3-1) et configurée pour fournir un premier signal de commande (15-1) à la résistance de commande (44-1) de la première commande de puissance à semi-conducteurs, dans lequel la commande est en communication électrique avec la seconde commande de puissance à semi-conducteurs (3-2) et est configurée pour fournir un second signal de commande (5-2) à la résistance de commande (44-2) de la seconde commande de puissance à semi-conducteurs ; et
une sortie de canal combinée (7),
dans lequel le premier circuit de commutation de courant de canal (33) est disposé en série entre la sortie de canal combinée (7) et le premier canal de sortie (8-1),
dans lequel le second circuit de commutation de courant de canal (33) est disposé en série entre la sortie de canal combinée (7) et le second canal de sortie (8-2),
dans lequel le premier circuit de commutation de courant de canal (33) est conçu pour commander un premier courant fourni par le premier canal de sortie (8-1) en réponse au premier signal de commande depuis la commande (6), et
dans lequel le second circuit de commutation de courant de canal (33) est conçu pour commander un second courant fourni par le second canal de sortie (8-2) en réponse au second signal de commande depuis la commande (6).

2. Système de commande de puissance à semi-conducteurs évolutif selon la revendication 1, dans lequel chacun de la pluralité de canaux de sortie (8-1...8-4) a des capacités de courant différentes.

3. Système de commande de puissance à semi-conducteurs évolutif selon la revendication 1 ou 2, dans lequel une capacité de courant de la sortie de canal combinée (7) est supérieure à une capacité de courant d'au moins l'un de la pluralité de canaux de sortie (8-1...8-4).

4. Système de commande de puissance à semi-conducteurs évolutif selon la revendication 1, 2 ou 3, dans lequel le premier circuit de commutation de courant de canal (33) comprend :
une rangée de limiteurs de courant de canal (54) comprenant une pluralité de chemins de conduction variable ;
un bus (51) comprenant un seul chemin de conduction, en communication électrique avec chaque chemin de conduction variable de la rangée de limiteurs de courant de canal (54) ; et
un bus de commande de grille (52) par lequel la pluralité de chemins de conduction variable sont commandés.

5. Système de commande de puissance à semi-conducteurs évolutif selon la revendication 4, dans lequel chacun des chemins de conduction variable comprend un transistor à effet de champ.

6. Système de commande de puissance à semi-conducteurs évolutif selon la revendication 4 ou 5, dans lequel
le bus de commande de grille (52) est commandé par le circuit de rétroaction de sortie (34) et le circuit de commande (32) ;
dans lequel le circuit de commande (32) est en communication électrique avec la commande (6) et le bus de commande de grille (52), et
dans lequel le circuit de rétroaction de sortie (34) est en communication électrique avec la sortie de canal combinée (7) et le bus de commande de grille (52).

7. Système de commande de puissance à semi-conducteurs évolutif selon la revendication 6, dans lequel le circuit de rétroaction de sortie (34) de la première commande de puissance à semi-conducteurs (3-1) comprend :
une résistance de détection (65) en série avec la sortie de canal combinée (7) ;
un transistor à jonction bipolaire comprenant une base, un collecteur et un émetteur, dans lequel la résistance de détection (65) est en communication électrique avec la base et l'émetteur, et dans lequel le collecteur est en communication électrique avec le circuit de commande (32).

8. Système de commande de puissance à semi-conducteurs évolutif selon la revendication 7, dans lequel le circuit de rétroaction de sortie (34) de la première commande de puissance à semi-conducteurs (3-1) comprend un amplificateur (63) disposé entre la résistance de détection (65) et la base.

9. Système de commande de puissance à semi-conducteurs évolutif selon la revendication 7 ou 8, dans lequel le premier circuit de commutation de courant de canal (33) comprend un amortisseur inductif (64) dans au moins une configuration parmi :
disposé entre le bus limiteur de courant (51) de la sortie de canal combinée (7) et la résistance de détection (65) du circuit de rétroaction de sortie (34), et entre la résistance de détection (65) du circuit de rétroaction de sortie (34) et la sortie de canal combinée (7).

10. Système de commande de puissance à semi-conducteurs évolutif selon l'une quelconque des revendications 6 à 9, dans lequel
l'équilibreur de circuit de commande/circuit de rétroaction (35) est en communication électrique avec la commande (6), le circuit de rétroaction de sortie (34) et le bus de commande de grille (52), le bus de commande de grille (52) étant commandé en réponse à la commande (6) et au circuit de rétroaction de sortie (34).

11. Système de commande de puissance à semi-conducteurs évolutif selon la revendication 10, dans lequel la résistance de commande (44) est en série avec la commande (6) et le bus de commande de grille (52) ; et
la résistance de rétroaction (61) est en série avec le collecteur du transistor à jonction bipolaire du circuit de rétroaction de sortie (34) et le bus de commande de grille (52).

12. Système de commande de puissance à semi-conducteurs évolutif selon l'une quelconque des revendications 4 à 11, dans lequel le protecteur de surtension (41) est en série avec une référence de tension (31) et le bus de commande de grille (52).

13. Système de commande de puissance à semi-conducteurs évolutif selon la revendication 12, dans lequel le protecteur de surtension (31) de la première commande de puissance à semi-conducteurs (3-1) comprend :
une diode Zener (42) en série à polarisation inverse avec la référence de tension (31) ; et
une diode de puissance (43) en série à polarisation directe entre la diode Zener (42) et le bus de commande de grille (52).

14. Système de commande de puissance à semi-conducteurs évolutif selon une quelconque revendication précédente, dans lequel la première commande de puissance à semi-conducteurs (3-1) comprend en outre une charge réactive (4) reliée en communication électrique à la sortie de canal combinée (7).

15. Procédé de fonctionnement d'une commande de puissance à semi-conducteurs (3-1, 3-2, 3-3, 3-4) comprenant :
la fourniture, par une commande (6), d'un premier et d'un second signal de commande (5-1,5-2) dirigeant un premier et un second circuit de commutation de courant de canal (33) pour fournir un courant sur un premier et un second bus limiteur de courant (51) en réponse à une tension présentée sur un premier et un second bus de commande de grille (52) ;
la fourniture, par la commande (6), d'une référence de tension aux premier et second circuit de commutation de courant de canal par l'intermédiaire d'un premier et d'un second protecteur de surtension (41) et à un premier et un second équilibreur de circuit (35) par l'intermédiaire du premier et du second protecteur de surtension (41), la référence de tension correspondant à une tension nominale présentée au niveau d'un canal ;
la détection, par les premier et second circuit de rétroaction de sortie (34), du courant fourni à la sortie de canal combinée (7) ;
la fourniture, par les premier et second circuit de rétroaction de sortie (34), d'une rétroaction aux premier et second circuit de commutation de courant de canal (33) faisant varier la tension présentée sur le premier et le second bus de commande de grille (52) ; et
le maintien du courant fourni à la sortie de canal combinée (7) dans une limite souhaitée en réponse à la tension présentée sur le premier et le second bus de commande de grille (52),
dans lequel le premier et le second équilibreur de circuit comprennent une résistance de rétroaction (61) et une résistance de commande (44) reliées aux premier et second protecteur de surtension par un nœud commun entre la résistance de rétroaction et la résistance de commande, le premier et le second signal de commande étant fournis à la résistance de commande du premier et du second équilibreur de circuit.
